# EUROPEAN PATENT APPLICATION

(11) **EP 4 819 790 A1**
(43) Date of publication of application: **07.10.2026**
(21) Application number: 25167933.8
(22) Date of filing: 02.04.2025
(51) Int. Cl.: H10D 18/01, H10D 18/80, H10D 62/17, H10D 64/27, H10D 62/10

(54) **BIDIRECTIONAL THYRISTOR, BYPASS CIRCUIT AND METHOD MANUFACTURING THE BIDIRECTIONAL THYRISTOR**

(71) Applicant: Hitachi Energy Ltd, 8050 Zürich (CH)
(72) Inventor: Vobecky, Jan, 16000 Praha 6 (CZ); Pina, Libor, 19300 Praha 9 (CZ)
(74) Representative: Michalski Hüttermann & Partner mbB

(57) **Abstract**

The invention relates to a semiconductor device, a bypass circuit comprising the semiconductor device and a method manufacturing the semiconductor device. The semiconductor device (1) comprising a first thyristor structure (10) and a second thyristor structure (20) which are antiparallel connected and share a common semiconductor body (2). A first main electrode (51) functions as a cathode (11) for the first thyristor structure (10) and an anode (22) for the second thyristor structure (20). A second main electrode (52) functions as an anode (12) for the first thyristor structure and a cathode (21) for the second thyristor structure (20). The semiconductor body further comprises a first trigger region (61) and a first emitter region (71) facing the first gate and main electrodes, a second trigger region (62) and a second emitter region (72) facing the second gate and main electrodes to facilitate self-destruction of the thyristor structures.

## Description

### Technical Field

The invention relates to the technical field of semiconductor devices, in particular, a thyristor-based semiconductor device, a bypass circuit including the semiconductor device and a method for manufacturing the semiconductor device.

### Background Art

Modular multilevel converters, MMC, have gained significant attention in power electronics due to their modular design, scalability in terms of current and voltage, and their ability to significantly improve harmonic performance and reduce energy losses compared to conventional two-level and three-level converters. The MMC concept encompasses various topologies, among which the Half-Bridge, HB, and mixed Half-Bridge - Full-Bridge, HB-FB, MMC configurations are of particular interest in high-power applications.

To ensure reliable operation under fault conditions, MMCs require robust fault protection mechanisms. In particular, they rely on power semiconductor switches such as Insulated Gate Bipolar Transistors, IGBTs, or Integrated Gate Commutated Thyristors, IGCTs, with long-term short-circuit failure mode, SCFM, capability. Alternatively, special protection devices are employed in parallel with the MMC cell or the switching elements in a typical MMC cell. These protection circuits generally utilize pyrotechnic switches or circuit-commutated thyristors, which can be either unidirectional or bidirectional.

Existing unidirectional thyristors can be triggered under high voltage to share system surge currents, thereby preventing damage to the power semiconductor devices. Commercially available bidirectional thyristors, on the other hand, incorporate a permanent gate-to-cathode short within their ceramic housing. These devices act as bypass elements but do not contribute to surge current sharing. Additionally, they require high voltages to break down into a short-circuit state. This can result in excessive di/dt stresses, leading to damage to other power semiconductor devices in the MMC cell and uncontrolled energy discharge from the cell capacitor.

Moreover, a critical failure scenario arises when the corresponding power semiconductor device experiences a short-circuit failure, leading to a low cathode-anode voltage across the bidirectional thyristor. This condition is particularly challenging during a "black start", where the MMC cell must be shorted with zero voltage across the cell capacitor. In such cases, conventional thyristors may be unable to trigger normally, thereby limiting the energy required to permanently short the MMC cell.

Document EP 4 007 139 B1 provides a bidirectional thyristor as a switchable bypass device which can be triggered into a permanent ON state in response to a single trigger pulse. However, this bidirectional thyristor requires a high voltage difference across its first and second main electrodes to be triggered and is unable to handle the fault situation where the anode voltage is low.

Accordingly, there is a need for an improved protection semiconductor device that addresses the limitations of existing bidirectional thyristors, ensuring reliable and effective fault protection for MMC cells under all possible failure scenarios.

### Summary of invention

It is therefore an object of the invention to provide a novel semiconductor device with a bidirectional thyristor structure specifically designed to achieve reliable bypassing and permanent shorting under arbitrary fault conditions, thereby enhancing robustness and operational safety of the semiconductor device as a protection circuit.

The object of the invention is solved by independent claims. Preferred implementations are detailed in the dependent claims.

Thus, the object is solved by a semiconductor device comprising:
a first thyristor structure and a second thyristor structure antiparallel connected to each other,
a semiconductor body extending in an axial direction with a first surface and a second surface opposite to the first surface,
a first gate electrode and a first main electrode disposed on the first surface and spaced from each other,
a second gate electrode and a second main electrode disposed on the second surface and spaced from each other, wherein
the semiconductor body comprises a first base layer of a first conductivity type, a second base layer of a second conductivity type and a third base layer of the first conductivity type stacked in the axial direction, the second conductivity type is different from the first conductivity type,
the first gate electrode comprises a first guiding region extending in a radial direction on the first surface,
the second gate electrode comprises a second guiding region extending in a radial direction on the second surface,
a first trigger region of the first conductivity type is disposed in the first base layer facing the first guiding region, the first gate electrode is electrically connected to the first trigger region, the first trigger region has a doping concentration higher than the first base layer,
a second trigger region of the first conductivity type is disposed in the third base layer facing the second guiding region, the second gate electrode is electrically connected to the second trigger region, the second trigger region has a doping concentration higher than the third base layer,
a first emitter region of the second conductivity type is disposed in the first base layer facing the first main electrode and is radially spaced from the first trigger region, the first main electrode is electrically connected to the first emitter region and the first base layer, the first emitter region has a doping concentration higher than the first base layer, and
a second emitter region of the second conductivity type is disposed in the third base layer facing the second main electrode and is radially spaced from the second trigger region, the second main electrode is electrically connected to the second emitter region and the third base layer, the second emitter region has a doping concentration higher than the third base layer.

Here, the first main electrode functions as a cathode for the first thyristor structure and an anode for the second thyristor structure, while the second main electrode functions as a cathode for the second thyristor structure and an anode for the first thyristor structure. Thus, with respect to the blocking direction, the first and second thyristor structures are arranged in antiparallel, sharing the same semiconductor body and the main electrodes. The first gate electrode and the second gate electrode function respectively for the first and second thyristor structures. In addition, the first conductivity type is P-type, and the second conductivity type is N-type, or vice versa.

A key point of the present invention is the symmetrical design of the semiconductor device. With this design, the thyristor structures can serve to protect the FB and FB-HB MMC cells by adapting to the changing polarity of a main electrode voltage or AC voltages. The gates of the two thyristor structures can be activated at the same time regardless of the main electrode voltage polarity.

Moreover, the combination of the guiding regions and the corresponding trigger regions with higher doping concentrations enables the breakdown of the thyristor structures even when the main electrode voltage is low. When the main electrode voltage is lower than the gate driving voltages applied to the gate electrodes, most of the current concentrates and flows along the trigger regions to the emitter regions, leading to a high current density that accurately destroys the blocking junctions of the thyristor structures within a short response time. Consequently, the semiconductor device can serve as a highly reliable protection device under arbitrary fault conditions.

According to a preferred implementation of the present invention, the first base layer and the second base layer form a first blocking junction. The third base layer and the second base layer form a second blocking junction. The first blocking junction may comprise a first protruding platform toward the first trigger region and the at least part first emitter region, and the second blocking junction may comprise a second protruding platform toward the second trigger region and at least part the second emitter region.

In other words, beneath the trigger regions and the emitter regions, the corresponding blocking junctions formed by the base layers may be closer to the surfaces of the semiconductor body in the axial direction. These shallower blocking junctions can make the device more susceptible to damage, which in turn reduces a fail-to-short-circuit response time of the semiconductor device and lowers the required gate driving voltages for triggering.

According to a preferred implementation of the present invention, the semiconductor device may further comprise a first anode region of the first conductivity type and a second anode region of the first conductivity type. The first anode region may be disposed in the first base layer facing the first main electrode while the second anode region may be disposed in the third base layer facing the second main electrode. The first anode region may be radially aligned to the first emitter region. The second anode region may be radially aligned to the second emitter region. The first main electrode and the second main electrode may be electrically connected to the first anode region and the second anode region respectively. In addition, the first anode region may have a doping concentration higher than the first base layer while the second anode region may have a doping concentration higher than the third base layer.

In this design, the first anode region may function as an anode region of the second thyristor structure, while the second anode region may function as an anode region of the first thyristor structure. When the main electrode voltage is higher than the gate driving voltages applied to the gate electrodes, the thyristor structures can be triggered by the gate driving voltages following classical thyristor operation. In addition to the lateral current between the trigger regions and the emitter regions, current may also flow between the emitter and anode regions.

In this implementation, the first and the second anode regions may be disposed in circular regions respectively encircling the first and the second emitter regions. This may help to resemble large size cathode shorts.

Optionally, the first anode region may be separated from the first emitter region while the second anode region may be separated from the second emitter region.

Optionally, the semiconductor device may further comprise a first blocking region of the second conductivity type disposed in the first base layer and a second blocking region of the second conductivity type disposed in the third base layer. The first and the second blocking region may be disposed in circular regions respectively encircling the first and the second anode regions. The first blocking region may have a doping concentration higher than the first base layer and the second blocking region may have a doping concentration higher than the third base layer. The blocking regions can facilitate to secure current crowding within the thyristor structure. In addition, it may enable the provision of other device structure encircling the thyristor structures.

According to an alternative preferred implementation of the present invention, when observing along the axial direction, the first guiding region maybe angularly offset from the second guiding region and the first emitter region may be angularly offset from the second emitter region in a same manner. The semiconductor device may further comprise a third anode region disposed in the first base layer directly opposite to the second emitter region, and a fourth anode region disposed in the third base layer directly opposite to the first emitter region. The third anode region is of the first conductive type and may have a doping concentration higher than the first base layer, while the fourth anode region is of the first conductive type and may have a doping concentration higher than the third base layer.

In this implementation, the trigger regions and the emitter regions on opposite surfaces are mutually shifted. Corresponding anode regions are then arranged axially opposite to the emitter regions to provide thyristor structures to be turned on with a straight current flow between the anode regions and the emitter regions.

According to a preferred implementation of the present invention, the semiconductor device may comprise multiple first guiding regions extending in different radial directions, multiple second guiding regions extending in different radial directions. Correspondingly, multiple first trigger regions may be disposed in the first base layer, each facing one of the multiple first guiding regions, and multiple second trigger regions may be disposed in the third base layer, each facing one of the multiple second guiding regions. The semiconductor device may further comprise multiple first emitter regions disposed in the first base layers facing the first main electrode and radially aligned to the multiple first trigger regions to form multiple first sacrificial regions, and multiple second emitter regions disposed in the third base layer facing the second main electrode and radially aligned to the multiple second trigger region to form multiple second sacrificial regions.

Alternatively, the first emitter region may be disposed in a circular region encircling the multiple first trigger regions to form the multiple first sacrificial regions, and the second emitter region may be disposed in a circular region encircling the multiple second trigger regions to form the multiple second sacrificial regions.

Alternatively, the first emitter regions may comprise a circular region encircling the multiple first trigger regions and multiple protruding regions which protrudes radially from the circular region towards the first trigger regions. The second emitter regions may comprise a circular region encircling the multiple second trigger regions and multiple protruding regions which protrudes radially from the circular region towards the second trigger regions. These designs may further facilitate local overloading of current between the trigger regions and the protruding regions.

The provision of multiple trigger regions and emitter regions distributed throughout the semiconductor body may create multiple potential failure points, thereby increasing the area of shorted region leading and hereby lowering the electrical resistance between the shorted electrodes and improving more effective circuit protection under fault conditions.

Optionally, the number of the first and the second sacrificial regions are between 2 to 8, preferably, between 3 to 6. The multiple pairs of the trigger regions and emitter regions may be rotationally symmetrical with respect to a central axis of the semiconductor body.

According to another preferred implementation of the present invention, the semiconductor device may further comprise a breakover diode encircling the first and the second thyristor structures.

In this implementation, the semiconductor body may comprise a third trigger region of the first conductivity type disposed in the first based layer facing the first main electrode. The third trigger region may be disposed in a circular region encircling the first emitter region and be spaced from the first emitter region. The third trigger region may have a doping concentration higher than the first base layer and equal to or lower than the first trigger region. The semiconductor body may further comprise a fourth trigger region of the first conductivity type disposed in the third based layer facing the second main electrode. The fourth trigger region may be disposed in a circular region encircling the second emitter region and be spaced from the second emitter region. The fourth trigger region may have a doping concentration higher than the third base layer and equal to or lower than the second trigger region.

In this implementation, the semiconductor device is then equipped with parallel breakover diode structure. When it comes to the fault condition with high applied voltage, the breakover diode structure may be subjected to punch-through or breakdown effect when the voltage between the first and the second main electrodes exceeds a breakover voltage of the breakover diode.

Optionally, the semiconductor body may comprise a junction termination region extending outside an outer circumference of the first main electrode and an outer circumference of the second main electrode. The junction termination region may encircle the breakover diode structure and have a reverse breakdown voltage higher than a breakover voltage of the breakover diode structure.

When it comes to the breakdown of the semiconductor body due to the high applied voltage, the breakdown could happen only in the bulk inside the junction termination region, thereby avoiding arcing at the periphery of the semiconductor body, which could lead to explosion.

Optionally, a vertical thickness of the semiconductor body may be gradually reduced from the outer circumferences of the first and the second main electrodes to a circumferential side the semiconductor body. That is, the semiconductor body comprises negative bevels at its periphery to form the junction termination region.

According to a preferred implementation of the present invention, a depth of the first blocking junction in the thyristor structure may be smaller than a depth of the first blocking junction in the breakover diode structure, and a depth of the second blocking junction in the thyristor structure may be smaller than the depth of the second blocking junction in the breakover diode structure.

In this implementation, compared to the thyristor structures, the first and third base layers have a deeper doping profile in the breakover diode region. On the one hand, the shallow doping profile at the thyristor structures can increase the probability of breakdown by the induced gate pulse currents. On the other hand, the deeper doping profile in the breakover diode structure makes it possible to break down by punch-through effect at lower voltages than the rest of the device.

Optionally, a thickness of the first main electrode may be larger than a thickness of the first guiding region and a thickness of the second main electrode may be larger than a thickness of the second guiding region.

With a thickness difference, the surface of the main electrodes away from the semiconductor body may be higher than the surface of the guiding regions of the gate electrodes. With this design, metal contact layers attached to the main electrodes can extend toward the guiding regions and define gaps between the metal contact layers and the guiding regions to avoid dangerous arcing.

The objective is further solved by a bypass circuit comprising a semiconductor device as discussed above. The bypass circuit may further comprise a first gate circuit electrically connected to the first gate electrode and the first main electrode, and a second gate circuit electrically connected to the second gate electrode and the first main electrode. The first gate circuit is configured to supply a gate driving voltage to the first gate electrode to induce a first gate pulse current flowing from the first trigger region to the first emitter region, and the second gate circuit is configured to supply a gate driving voltage to the second gate electrode to induce a second gate pulse current flowing from the second trigger region to the second emitter region.

The induced gate pulse current may destroy the blocking junctions beneath trigger regions and the emitter regions and turn the semiconductor device into a permanent short circuit. The magnitude of the gate driving voltages may be chosen up to 150 V, preferably in a range of 15 V to 60 V to provide enough energy for the destruction on one hand and to enable practical construction of the gate driver circuit using low-volume low voltage components on the other hand. For special applications, higher gate driving voltage, e.g. up to 300 V, can be used.

The objective is further solved by a method for manufacturing in particular a semiconductor device as described above. The method comprises the steps of:
forming a semiconductor body with a first base layer of a first conductivity type, a second base layer of a second conductivity type and a third base layer of the first conductivity type stacked in the axial direction,
forming a first trigger region of the first conductivity type and a first emitter region of the second conductivity type in the first base layer, and a second trigger region of the first conductivity type and a second emitter region of the second conductivity type in the third base layer,
forming a first gate electrode towards the first trigger region and a first main electrode towards the first emitter region, and a second gate electrode towards the second trigger region and a second main electrode towards the second emitter region,
the second conductivity type is different from the first conductivity type, and
doping concentrations of the first trigger region, the second trigger region, the first emitter region and the second emitter region are higher than the first and the third base layers.

Specifically, the semiconductor body may be formed with pre-deposition of aluminium for subsequent diffusion into a wafer bulk. In addition, the method may involve wet chemical etching of the pre-deposited aluminium layer from at least part of the thyristor structures to prevent diffusion into the bulk. This may result in a shallower doping profile in at least part of the thyristor structures.

Further implementations and advantageous of the method can be derived from the semiconductor device described above.

### Brief description of drawings

These and other aspects of the invention will be apparent from and elucidated with reference to the implementations described hereinafter.

In the drawings:
Fig. 1 shows a cross-sectional diagram illustrating a bidirectional thyristor structure according to an implementation of the present invention.
Fig. 2 shows a cross-sectional diagram illustrating a bidirectional thyristor structure according to another implementation of the present invention.
Fig. 3 shows another cross-sectional diagram illustrating the bidirectional thyristor structure depicted in Fig.2.
Fig. 4 shows top view diagram illustrating trigger regions and emitter regions according to an implementation of the present invention.
Fig. 5 shows top view diagram illustrating trigger regions and emitter regions according to another implementation of the present invention.
Fig. 6 shows top view diagram illustrating first trigger regions and first emitter regions according to another implementation of the present invention.
Fig. 7 shows top view diagram illustrating first trigger regions and first emitter regions on a first surface according to another implementation of the present invention.
Fig. 8 shows bottom view diagram illustrating second trigger regions and second emitter regions according to the implementation depicted in Fig. 7.
Fig. 9 shows a cross-sectional diagram illustrating a semiconductor device with the bidirectional thyristor structure, a breakover diode structure and a junction termination region according to an implementation of the present invention.
Fig. 10 shows an enlarged view of Fig. 9 illustrating the doping profile according to an implementation of the present invention.
Fig. 11 shows a cross-sectional diagram illustrating a semiconductor device with electrodes of different thicknesses and corresponding metal contact layers according to an implementation of the present invention.
Fig. 12 illustrates a bypass circuit according to an implementation of the present invention.
Fig. 13 is a flow chart of a method for manufacturing the semiconductor device according to an implementation of the present invention.
Fig. 14 is a flow chart of the method steps forming electrodes with different thickness according to an implementation of the present invention.

### Description of implementations

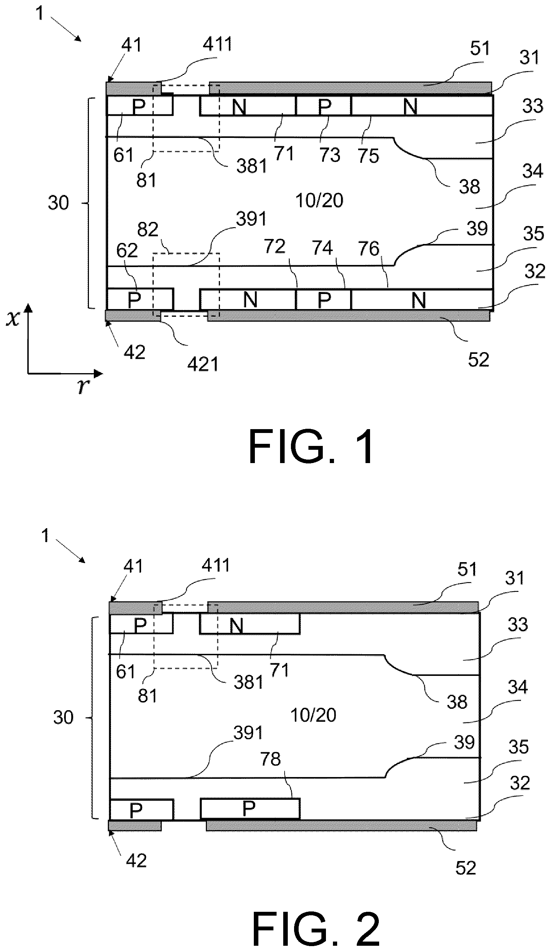

Fig. 1 shows a cross-sectional diagram illustrating a bidirectional thyristor structure of a semiconductor device 1 according to an implementation of the present invention. The bidirectional thyristor structure is composed of a first thyristor structure 10 and a second thyristor structure 20 connected in antiparallel. It should be noted that the cross-sectional diagram view is a half-section illustration to clearly present the bidirectional thyristor structure. This bidirectional thyristor structure may be rotationally symmetric at intervals within the semiconductor device.

In the figures, the first conductivity type is P-type, the second conductivity type is N-type. In practical, the first conductivity type may be N-type and the second conductivity type may be P-type.

As depicted in Fig. 1, the first and the second thyristor structure 10/20 share a common semiconductor body 30. The semiconductor body 30 extends in an axial direction x with a first surface 31 and a second surface 32 which is opposite to the first surface 32. The semiconductor body 30 shown in Fig. 1 comprises a P-N-P structure comprising a first base layer 33 of P-type, a second base layer 34 of N-type and a third base layer 35 of P-type stacked along the axial direction *x*. The base layers may be formed as low-doped N-base and two P-base regions within the semiconductor body 30. Doping concentrations of the base layers may be determined based on practical needs.

The semiconductor device 1 further comprises a first gate electrode 41 and a first main electrode 51, both disposed on the first surface 31 and spaced from each other, as well as a second gate electrode 42 and a second main electrode 52, both disposed on the second surface 32 and spaced from each other. The first gate electrode 41 and the second gate electrode 42 may be disposed at the centres of the first and second surfaces and extend along a radial direction *r*. The main electrodes may be disposed encircling the gate electrodes.

Although not depicted in Fig. 1, the main electrodes may be insulated from the gate electrodes, preferably, by insulating layers. The first main electrode 51 may function as a cathode for the first thyristor structure 10 and an anode for the second thyristor structure 20, while the second main electrode 52 may function as an anode for the first thyristor structure and a cathode for the second thyristor structure 20.

Fig. 1 further illustrates that the first main electrode 51 comprises a first guiding region 411 extending in the radial direction *r* on the first surface 31. Correspondingly, a first trigger region 61 of P-type is formed in the first base layer 33. The first trigger region 61 faces and is electrically connected to the first guiding region 411. The first trigger region 61 has a doping concentration higher than that of the first base layer 33.

Radially opposite to and aligned with the end of the first trigger region 61, a first emitter region 71 of N-type is formed in the first base layer 33. The first emitter region 71 faces and is electrically connected to the first main electrode 51. The first emitter region 71 is radially spaced from the first trigger region 61 by the first base layer 33. The first emitter region 71 has a doping concentration higher than that of the first base layer 33. In this implementation, the first trigger region 61 may serve as a gate region of the first thyristor structure, and the first emitter region 71 may serve as a cathode region of the first thyristor structure 10.

Symmetrically, the second gate electrode 42 comprises a second guiding region 421 extending in the radial direction *r* on the second surface 32. A second trigger region 62 of P-type is formed in the third base layer 35. The second trigger region 62 faces and is electrically connected to the second guiding region 421. The second trigger region 62 has a doping concentration higher than that of the third base layer 35.

Radially opposite to and aligned with the end of the second trigger region 62, a second emitter region 72 of N-type is formed in the third base layer 35. The second emitter region 72 faces and is electrically connected to the second main electrode 52. The second emitter region 72 is radially spaced from the second trigger region 62 by the third base layer 35 and has a doping concentration higher than the third base layer 35. In this implementation, the second trigger region 62 may serve as a gate region of the second thyristor structure 20 and the second emitter region 72 may serve as a cathode region of the second thyristor structure 20. The trigger regions and the emitter regions may have a same thickness of different thicknesses.

As shown in Fig. 1, the first trigger region 61 and the first emitter region 71 may form a first sacrificial region 81 between them, while the second trigger region 62 and the second emitter region 72 may form a second sacrificial region 82 between them accordingly. Dashed lines are only used to virtually mark the sacrificial regions for explanatory purposes.

When the gates of the thyristor structures are activated by a gate driving voltage *V_{G}*, current concentrates and flows from the trigger regions to the emitter regions, leading to a high current density that accurately destroys the blocking junctions in the sacrificial regions from both sides within a short response time. Thus, it is possible to destroy the semiconductor device in response to a single gate pulse without activating the thyristor structures. In other words, the first and second tigger regions may be configured to guide current flowing to the emitter regions for destroying the blocking junctions.

Moreover, to further reduce the response time and increase the probability of the deconstruction, the blocking junctions may be formed closer to the trigger regions and emitter regions. As shown in Fig. 1, a first blocking junction 38, formed between the first base layer 33 and the second base layer 34, may comprise a first protruding platform 381 extending toward the first trigger region 72 and the first emitter region 71. A second junction 39, formed between the third base layer 35 and the second base layer 34, may also comprise a second protruding platform 391 extending toward the second trigger region 62 and the second emitter region 72.

The protruding platforms, namely the shallower blocking junctions, may be formed at the centre of the semiconductor body extending toward the corresponding trigger regions and at least part of the emitter regions. A distance between the first blocking junction 38 and the first surface 31, as well as a distance between the second blocking junction 39 and the second surface 32 may be ranged from 40 µm to 100 µm. Preferably, the distances may be ranged from 60 µm to 80 µm.

The implementation depicted in Fig.1 may further comprise a first anode region 73 of P-type and a second anode region 74 of P-type. The first anode region 73 may be formed in the first base layer 33 facing the first main electrode 51. The first anode region 73 may be radially aligned to the first emitter region 71. Specifically, the first anode region 73 may be electrically connected to the first main electrode 51 and have a doping concentration higher than the first base layer 33. Symmetrically, the second anode region 74 may be formed in the third base layer 35 facing the second main electrode 52. The second anode region 74 may be radially aligned with the second emitter region 72. In particular, the second anode region 74 may be electrically connected to the second main electrode 52 and have a doping concentration higher than the third base layer 35. The anode regions and the emitter regions may have a same thickness or different thicknesses.

In this design, the first anode region 73 may function as an anode region of the second thyristor structure, while the second anode region 74 may function as an anode region of the first thyristor structure.

The first and the second anode regions 73/74 may be formed in circular regions respectively encircling the first and the second emitter regions 71 /72. Although not depicted in Fig. 1, the first anode region 73 may be separated from the first emitter region 71 by the first base layer 33 while the second anode region 74 may be radially aligned with and spaced from the second emitter region 72 by the third base layer 35.

Moreover, the emitter and anode regions may have smaller areas compared to standard devices to promote current crowding, intentionally leading to local overloading, which results in the permanent shorting of both blocking junctions and, thereby, the whole semiconductor device 1.

Hence, the structure shown in Fig. 1 may have two distinct operation modes: (a) when a voltage difference *V* between the main electrodes is higher than the gate driving voltage *V_{G}* and (b) when a voltage difference V between the main electrodes is smaller than the gate driving voltage *V_{G}.* The magnitude of *V_{G}* may be chosen, but is not limited to, 15 - 50 V to provide enough energy for the destruction on one hand and to enable practical construction of the gate drive circuit using low-volume low-voltage components on the other hand.

In operation mode (a), one of the first and the second thyristor structures can be triggered by the gate driving voltage *V_{G}*, similar to conventional thyristor operation. Induced gate pulse currents can flow through the P-N-P structures between the gate regions and the cathode regions on both side, and then predominantly through the triggered thyristor P-N-P-N structure. Specifically, the current may first flow laterally from the trigger region to the emitter region and then to the anode region on both sides destroying both blocking junctions. Then, through the triggered thyristor structure, the current flows vertically from the anode region on one surface to the emitter region on the opposite surface to destroy both blocking junctions, preferably permanently. Which thyristor structure is triggered may depend on the polarity of *V*.

In operation mode (b), most of the gate pulse current can flow laterally through the P-N-P structure between the gate regions and the cathode regions, thereby destroying both blocking junctions simultaneously. When 0 *< V < V_{G},* one of the thyristor's P-N-P-N structure may be turned on with a very low current density. When *V* = 0, the thyristor structure may be off. The deconstruction leading to the short circuit of the semiconductor device may be achieved only by the lateral currents on both sides. The protection event can be controlled with only a single gate driving signal used for the destructive action at both sacrificial regions 81 and 82.

Optionally, as depicted in Fig. 1, a first blocking region 75 of N-type may be formed in the first base layer 33 encircling the first anode region 73, while a second blocking region 76 of N-type may be formed in the third base layer 35 encircling the second anode region 74. The first blocking region 75 may have a doping concentration higher than the first base layer 33 while the second blocking region 76 may have a doping concentration higher than the third base layer 35. The blocking regions help to secure current crowding in the thyristor structure. Specifically, the anode regions may be formed as circular P-type regions drawn in the N-type regions to resemble large-size cathode shorts. The blocking regions may have a same thickness or different thicknesses as the anode regions.

Although not depicted in Fig. 1, the first anode region 73 may be separated from the first blocking region 75 by the first base layer 33 while the second anode region 74 may be separated from the second blocking region 76 by the third base layer 35. Specific layouts of the trigger regions, emitter regions, and anode regions will be discussed later.

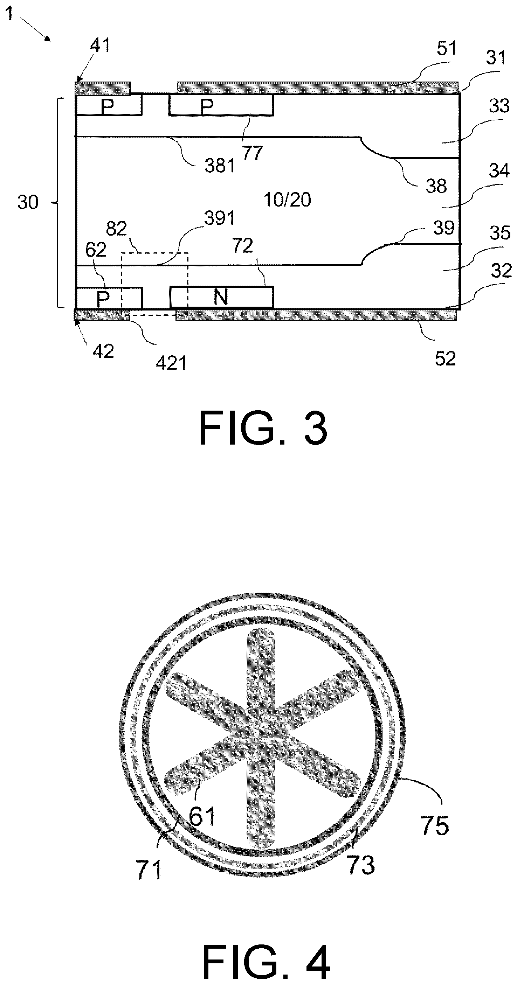

Fig. 2 and Fig. 3 show cross-sectional diagrams illustrating an alternative bidirectional thyristor structure of the semiconductor device 1 according to another implementation of the present invention. Fig. 2 and Fig. 3 depict the cross-sectional diagrams along different radial directions of the semiconductor device 1.

Different from the implementation shown in Fig.1, when observing along the axial direction *x*, the first guiding region 411 may be angularly offset from the second guiding region 421 while the first emitter region 71 may be angularly offset from the second emitter region 72 in the same manner. Correspondingly, the trigger regions may be shifted together with the guiding regions.

In this implementation, as shown in Fig. 2, a third anode region 77 of P-type may be formed in the first base layer 33 directly opposite to the second emitter region 72. Correspondingly, as shown in Fig. 3 a fourth anode region 78 of P-type may be formed in the third base layer 35 directly opposite to the first emitter region 71. The third anode region 77 may have a doping concentration higher than the first base layer 33 while the fourth anode region 78 may have a doping concentration higher than the third base layer 35.

Consequently, the oppositely arranged first emitter region 71 and fourth anode region 78 may form the N-P-N-P structure of the first thyristor structure 10 while the oppositely arranged second emitter region 72 and the third anode region 77 may form the N-P-N-P structure of the second thyristor structure 20 for the vertical current flow between the anode regions and the cathode regions. The specific layout of N/P masks forming the trigger regions, the emitter regions and the anode regions on both surfaces will be described later.

For both implementations shown in Fig. 1, Fig. 2 and Fig.3, the semiconductor device 1 may comprise multiple guiding regions extending in different radial directions as well as multiple pairs of trigger and emitter regions that are radially spaced and distributed along the semiconductor device 1. Hence, the semiconductor device 1 may comprise multiple sacrificial regions 81/82 where the blocking junctions could be destroyed by the gate pulse currents.

The number of the first and the second sacrificial regions ranges between 2 and 8, preferably, between 3 and 6. The sacrificial regions may be evenly distributed along the semiconductor device 1 so that it can be destroyed in a balanced manner. Fig. 4 to Fig. 8 depict top view or bottom view diagrams illustrating the layouts of the trigger regions and the emitter regions according to different implementations of the present invention. Fig. 4 to Fig. 8 shows only the internal part of the thyristor structure. Much larger peripheral region outside the thyristor structures may constitute the break-over diode.

Fig. 4 depicts a layout of the first trigger regions 61 and the first emitter regions 71 according to the implementation shown in Fig. 1 when viewing from the first surface 31. As shown in Fig. 4, the semiconductor device 1 may comprise six first trigger regions 61 extending in different radial directions and evenly distributed along the semiconductor device 1. An included angle between two adjacent first trigger regions 61 may be 60°. The first emitter region 71 may be formed to encircle the six first trigger regions 61 to form six corresponding first sacrificial regions 81. The first emitter regions 71 may be spaced from the edge of the first trigger regions 61 by the first base layer 33. Additionally, and optionally, the first anode region 73 may be formed in a circular region encircling the first emitter region while the first blocking region 75 may be formed in a circular region encircling the first anode region 73. The first emitter region 71, the first anode region 73 and the first blocking region may be spaced from each other by the first base layer. Further, widths of the first emitter region, the first anode region 73 and the first blocking region 75 may be substantially smaller than radial extensions of the first trigger regions 61 so as to enhance local current crowding. Although not depicted in the figures, the same layout may be provided symmetrically for the second trigger regions 62, the second emitter region 72, the second anode region 74 and the second blocking region 76 on the second surface 32 of the semiconductor device 1.

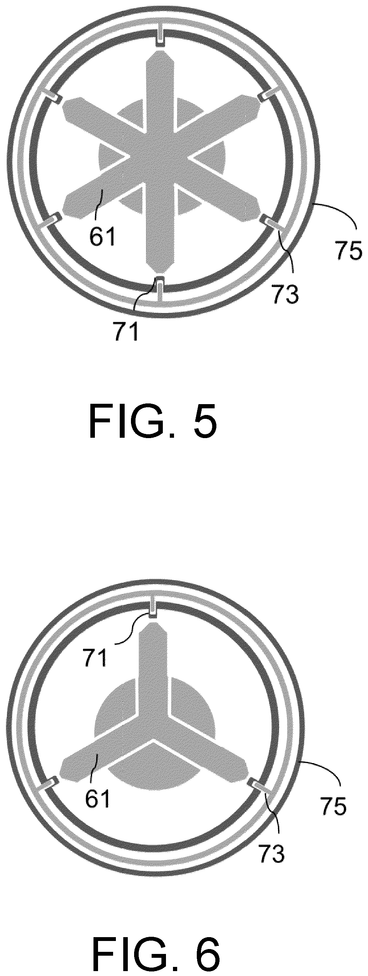

Fig. 5 depicts an alternative layout of the first trigger regions 61 and the first emitter regions 71 according to the implementation shown in Fig. 1 when viewed from the first surface 31. Different from the layout shown in Fig. 4, each first trigger region 61 extends radially and gradually narrows at its end. That is, the end of the first trigger region 61 is narrower than the main portion of the first trigger region 61. This design may facilitate current crowding.

Correspondingly, the first emitter region 71 may comprise a circular region encircling the six first trigger regions 61 and six protruding regions that protrude towards the ends of the first trigger regions 61 to form six corresponding first sacrificial regions 81. This design further facilitates the current crowding between the first trigger regions 61 and the first emitter regions 71. It should be noted that the first emitter regions 71, in particular, the protruding regions may still be spaced from the edge of the first trigger regions 61 by the first base layer 33.

In addition, the first anode region 73 may be formed in a circular region encircling the first emitter region, while the first blocking region 75 may be formed in a circular region encircling the first anode region 73. The first anode region 73 may also comprise protruding regions that protrude towards the protruding regions of the first emitter region 71.

The first emitter region 71, the first anode region 73, and the first blocking region may be spaced from each other by the first base layer. Optionally, floating P-type regions may be provided between the adjacent first trigger regions 61. The floating regions may also be spaced from the first trigger regions 61 by the first base layer 33 and have a doping concentration higher than that of the first base layer 33.

Although not depicted in the figures, the same layout may be provided symmetrically for the second trigger regions 62, the second emitter regions 72, the second anode region 74 and the second blocking region 76 on the second surface 32 of the semiconductor device 1. Fig. 5 shows only the internal part of the thyristor structure. Much larger peripheral region outside the blocking regions 75 may constitute the break-over diode.

Fig. 6 depicts a layout similar to the layout shown in Fig. 5 with the difference that the semiconductor device 1 comprises three first trigger regions. It is noted that the number of the trigger regions and the corresponding sacrificial regions may be chosen based on practical requirements. The number may range from 2 to 8, preferably from 3 to 6.

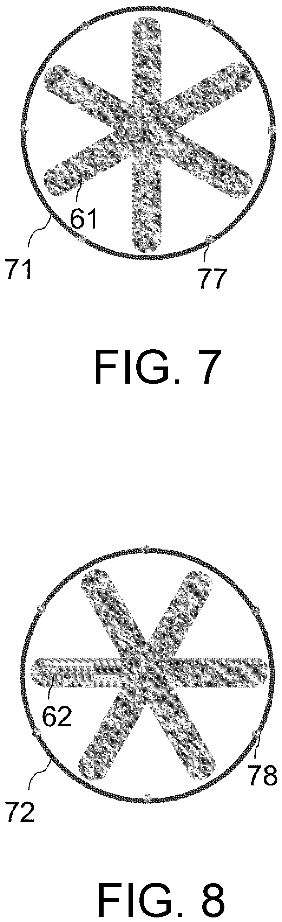

Fig. 7 and Fig. 8 show the respective layouts of the trigger regions and the emitter regions on the first surface 31 and the second surface 32 according to the implementation shown in Fig. 2 and Fig. 3. As shown in Fig. 7, the semiconductor device 1 may comprise six first trigger regions 61 extending in different radial directions and evenly distributed along the semiconductor device 1. An included angle between two adjacent first trigger regions 61 may be 60°.

The first emitter region 71 may comprise a circular region encircling the six first trigger regions, whereby the first trigger regions 61 form the corresponding sacrificial regions 81 with portions of the first emitter region 71 aligned with the ends of the first trigger regions 61. Six third anode regions 77 may be interlaced within the first emitter region 71 between two adjacent portions aligned with the ends of the first trigger regions 61. In other words, the third anode regions 77 may be formed aligned with a midpoint between two adjacent first trigger regions 61. At the same time, as shown in Fig. 8, the same N/P mask that forms the six second trigger regions 62, the second emitter region 72, and the six fourth anode regions 78 may be applied to the second surface and may be mutually offset with respect to the first trigger regions 61 by an angle. The offset angle may be 30°.

With the mutual offset, the third anode regions 77 may be axially aligned with the portions of the second emitter region 72 that radially aligned with the ends of the first trigger regions 62 to provide the P-N-P-N structure of the second thyristor structure 20. The fourth anode regions 78 may be axially aligned with the portions of the first emitter region 71 that radially aligned with the ends of the first trigger regions 61 to provide the P-N-P-N structure of the first thyristor structure 10.

Although not depicted in Fig. 7 and Fig. 8, the first and second emitter regions may also comprise protruding regions that protrude towards the ends of the trigger regions as shown in Fig. 5. Optionally, the trigger regions may also comprise narrower ends, as shown in Fig. 5, to facilitate current concentration.

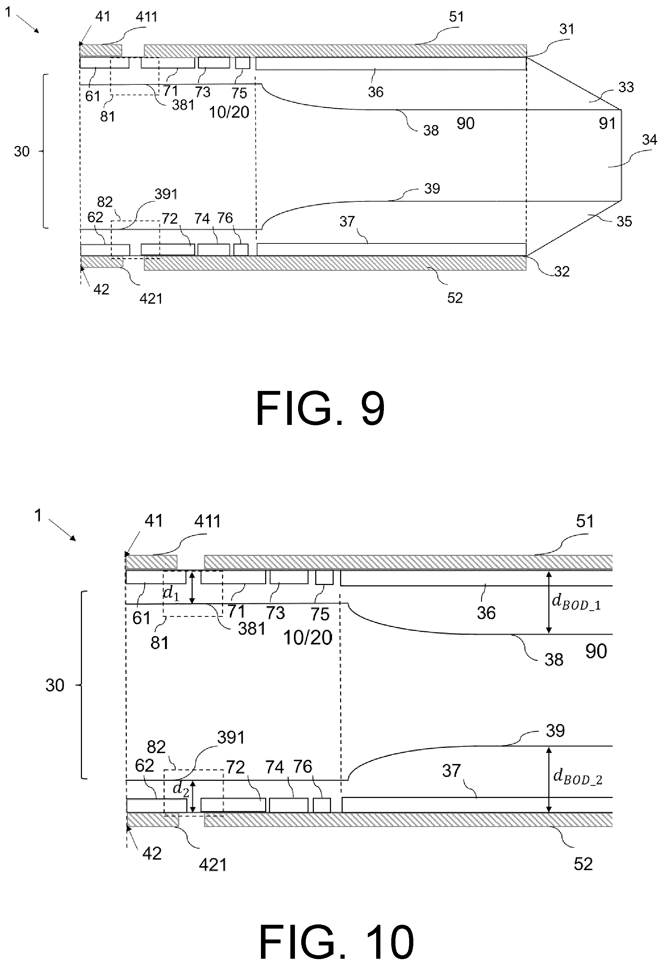

Fig. 9 shows a cross-sectional diagram illustrating the semiconductor device 1 with the bidirectional thyristor structure 10/20, a breakover diode structure 90 and a junction termination region 91 according to an implementation of the present invention. Dashed lines are only used to virtually separate different structures for explanatory purposes.

As shown in Fig. 9, the semiconductor device 1 may further comprise the breakover diode structure 90 encircling the first and the second thyristor structures 10 and 20. That is, the breakover diode structure 70 may share the semiconductor body 30 with the thyristor structures. As shown in Fig. 9, the semiconductor body 30 may further comprise a third trigger region 36 of P-type disposed in the first base layer 33 facing the first main electrode 51. A fourth trigger region 37 of P-type may be formed in the third base layer 35 facing the second main electrode 52. The fourth trigger region 37 may be formed in a circular region encircling the second emitter region 72.

To facilitate current crowding in the thyristor structure, the third trigger region 36 may be spaced from the first emitter region 71 while the fourth trigger region 37 may be spaced from the second emitter region 72. As shown in Fig. 9, when the implementation of the thyristor structures illustrated in Fig. 1 is employed, the third trigger region 36 may be spaced from the first blocking region 75 by the first base layer 33 while the fourth trigger region 37 may be spaced from the second blocking region 76 by the third base layer 35. Alternatively, when the implementation of the thyristor structures illustrated in Fig. 2 and Fig. 3 is employed, the third trigger region 36 may be spaced from the first emitter region 71 and the third anode region 77 by the first base layer 33 while the fourth trigger region 37 may be spaced from the second emitter region 72 and the fourth anode region 78 by the third base layer 35.

Optionally, the third trigger region 36 may have a doping concentration higher than the first base layer 33 and equal to or lower than the first trigger region 61 while the fourth trigger region 37 may have a doping concentration higher than the third base layer 35 and equal to or lower than the second trigger region 62. The third trigger region 36 and the fourth trigger region 37 may have widths significantly larger than the widths of the emitter regions and the anode regions, for instance, at least twice as large.

A breakover voltage *V_{BO}* of the diode may be adjusted by properly choosing the resistivity of starting silicon wafer in combination with wafer thickness. For specific applications, the breakover voltage *V_{BO}* may be a few hundred volts lower than a breakdown voltage of a power semiconductor device, such as an IGBT, to be protected. The breakover voltage *V_{BO}* may be ranged from 4000 V to 6000 V. Preferably, the breakover voltage *V_{BO}* may be 5000V ± 50 V. In this way, the breakover diode structure 90 may work as an emergency brake. If the thyristor structures do not fail into a short circuit, the breakover diode may be punched through or be subject to the break down effect with a sufficient high main electrode voltage *V*.

As further depicted in Fig. 9, the semiconductor body 30 may comprise the junction termination region 91 extending outside an outer circumference of the first main electrode 51 and an outer circumference of the second main electrode 52. The junction termination region 91 may be formed to encircle the breakover diode structure 90. Specifically, the junction termination region 91 may have a reverse breakdown voltage *V_{BR}* a few hundred volts higher than the breakover voltage *V_{BO}* of the breakover diode structure 90.

Hence, the breakdown of the diode 90 may only happen within the bulk and not inside the junction termination region 91, thereby avoiding arcing at the periphery of the semiconductor body, which could lead to an explosion. This can be achieved by high-energy electron radiation in the area of the junction termination region 91. The effect of the electron irradiation, which results in *V_{BR} > V_{BO}* consists of the reduced diffusion length of free carriers under the reverse bias of the open base P-N-P transistor structure in the electron irradiated region.

According to the implementation of Fig. 9, a vertical thickness of the semiconductor body 30 is gradually reduced from the outer circumferences of the first and the second main electrodes 51 and 52 to a circumferential side of the semiconductor body 30, thereby forming negative bevels for the junction termination region 91. Thicknesses of the trigger regions, emitter regions, anode regions and blocking regions may be the same or different.

As discussed above, to increase the probability of deconstruction, at least part of the thyristor structures 10/20 may comprise shallower blocking junctions. Fig. 10 shows an enlarged view of Fig. 9 illustrating the doping profile according to this implementation of the present invention. It can be seen from Fig. 10 that a depth *d*₁ of the first blocking junction 38 to the first surface 31 in the first sacrificial region 81 may be smaller than a depth *d_{BOD_1}* of the first blocking junction in the breakover diode structure 90. Symmetrically, a depth *d*₂ of the second blocking junction 39 to the second surface 32 in the first sacrificial region 82 may be smaller than the depth *d_{BOD_2}* of the second blocking junction in the breakover diode structure 90.

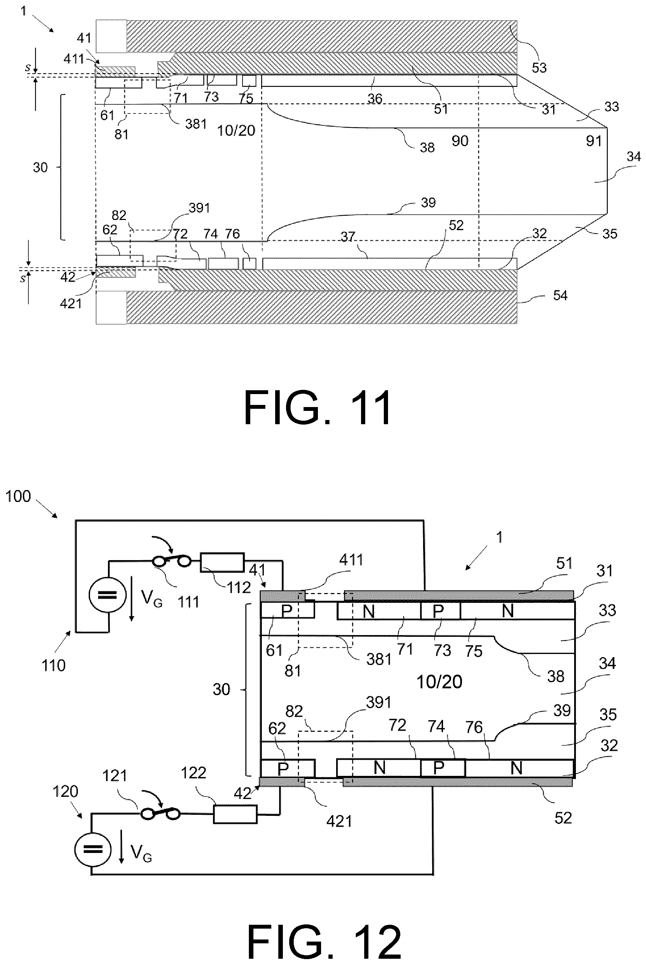

The shallower blocking junctions may be realized by the pre-deposition of an aluminium mask and wet etching. To bring the blocking junctions closer to the surfaces of the thyristor structures in the axial direction, the diffusion species may be locally etched away using a mask before their drive-in, resulting in the creation of etching steps with heights ranging from 5 to 10 µm, as shown in Fig. 11.

Fig. 11 shows a cross-sectional diagram illustrating the semiconductor device 1 with electrodes of different thicknesses and corresponding metal contact layers according to an implementation of the present invention.

As shown in Fig. 11, a thickness of the first main electrode 51 is larger than that of the first guiding region 411, and a thickness of the second main electrode 52 is larger than that of the second guiding region 421. It can be observed that the guiding regions of the gate electrodes are axially lower than the main electrodes. This may be achieved by a two-step masked formation of metal layers. First, a first metal layer may be formed in the centre portion of the gate electrodes and the main electrodes, then a second metal layer may be formed in the gate electrodes including the guiding regions and the main electrodes. In this way, the main electrodes may comprise two metal layers while the guiding regions may only comprise one metal layer, thereby creating the height difference. The metal layers may be made of copper, silver, titanium, nickel, aluminium, or stacks comprising at least two layers made of titanium, nickel, silver, and/or aluminium.

Optionally, the semiconductor device 1 may further comprise a first metal contact layer 53 attached to the first main electrode 51 and a second metal contact layer 54 attached to the second main electrode 52. The metal contact layers may be made of molybdenum, silver or other material with similar coefficient of thermal expansion as that of the silicon wafer forming the semiconductor body 30. The first metal contact layer 53 may extend toward the first guiding region 411, thereby covering and defining a first gap in the axial direction between the first metal contact layer 53 and the first guiding region 411, and the second metal contact layer 54 may extend toward the second guiding region 421, thereby covering and defining a second gap in the axial direction between the second metal contact layer 54 and the second guiding region 421. The metal contact layers may comprise through holes at their centres so that other components or circuits may connect to the centres of the gate electrodes via the through holes.

With this embodiment, the sacrificial regions 81/82 between the trigger regions and the emitter regions are covered by the metal contact layers, thereby protecting a encapsulation or a housing of the semiconductor device 1 from dangerous arcing that may appear during burning of the metal contact layers during destruction of the thyristor structures.

Fig. 12 illustrates a bypass circuit 100 according to an implementation of the present invention. The bypass circuit 100 comprise a semiconductor device 1 according to any of the implementations as discussed above. A first gate circuit 110 is electrically connected to the first gate electrode 41 and the first main electrode 51, and a second gate circuit 120 is electrically connected to the second gate electrode 42 and the first main electrode 52. The first gate circuit 110 is configured to supply a gate driving voltage *V_{G}* to the first gate electrode 41 to induce a first gate pulse current flowing from the first trigger region 61 to the first emitter region 71. The second gate circuit 120 is configured to supply a gate driving voltage *V_{G}* to the second gate electrode 42 to induce a second gate pulse current flowing from the second trigger region 62 to the second emitter region 72. The gate pulse currents thereby destroy the blocking junctions beneath the trigger regions and the emitter regions, creating a low-resistance path between the two main electrodes.

The gate voltage *V*_{G} may be chosen up to 300V, preferably, up to 150 V, more preferably, in a range of 15 V to 60 V, such as 20 V, 30V, 40 V and 50V. The first gate circuit 110 may comprise a gate capacitor, a switch 111 and a regulating component 112. The first gate circuit 120 may comprise a gate capacitor, a switch 121 and a regulating component 122. The regulating component may be a resistor, an inductor or other commonly used regulating components. The bypass circuit 100 may be applied to MMC cells. Alternatively, the bidirectional thyristor as shown in Fig. 2 can also be employed. Although not depicted in Fig. 12, the semiconductor device 1 may comprise the breakover diode structure 90 and the junction termination region 91.

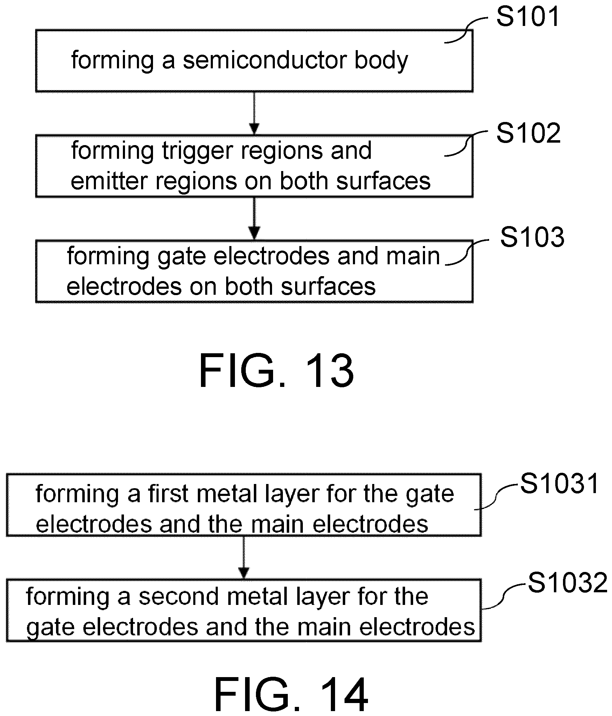

Fig. 13 is a flow chart of a method for manufacturing the semiconductor device according to any of the implementations as described above.

The method comprises the following steps of:
S101: forming the semiconductor body 30 with the first base layer 33 of the first conductivity type, the second base layer 34 of the second conductivity type and the third base layer 35 of the first conductivity type stacked in the axial direction,
S102: forming the first trigger region 61 of the first conductivity type and the first emitter region 71 of the second conductivity type in the first base layer 33, and the second trigger region 62 of the first conductivity type and the second emitter region 72 of the second conductivity type in the third base layer 35, and
S103: forming the first gate electrode 41 towards the first trigger region 61 and the first main electrode 51 towards the first emitter region 71, and the second gate electrode 42 towards the second trigger region 62 and the second main electrode 52 towards the second emitter region 72.

The first conductivity type may be P-type, the second conductivity type may be N-type, or vice versa. The processing on both sides of the semiconductor devices 1 is conducted simultaneously.

In detail, step S101 may be implemented by forming the first base layer 33 of the first conductivity type and the third base layer 35 of the second conductivity type simultaneously on opposite surfaces on a silicon wafer of the second conductivity type to form the semiconductor body 30.

Specifically, as discussed above, to form shallower blocking junctions, the semiconductor body 30 may be formed with the pre-deposition of aluminium for subsequent diffusion into a wafer bulk. Therefore, the step of forming (S101) the semiconductor body 30 may comprise:
S1011: providing a silicon wafer of the second conductivity type for the semiconductor body 30,
S1012: pre-depositing deep aluminium on the first surface 31 and the second surface 32,
S1013: applying resist masks on the first surface 31 and the second surface 32, leaving central portions of the first surface 31 and the second surface 32 uncovered,
S1014: wet etching the aluminium layers in the central portions,
S1015: removing the resist mask and driving in the aluminium dopants by diffusion,
S 1016: pre-depositing shallow aluminium on the first surface 31 and the second surface 32, and
S1017: driving in the aluminium dopants.

With this approach, the diffused P-type first base layer 33 and third base layer 35 are thinner in the central portion compared to the rest of the semiconductor body 30. Consequently, when the central portion of the semiconductor body 30 forms at least part of the thyristor structures, they can feature the shallower blocking junctions. A diameter of the uncovered central portions may be determined based on a diameter of the desired bidirectional thyristor structures. The diameter of the uncovered central portions may be equal to or smaller than the diameter of the desired bidirectional thyristor structure. The resist masks may be oxide or nitride masks. The pre-deposited aluminium may be aluminium dopants.

Optionally, the step of forming (S102) the trigger and emitter regions may comprise:
S1021: pre-depositing and driving in phosphorus for the first and second emitter regions, and
S1022: pre-depositing and driving in boron for the first and second trigger regions.

Shapes of the phosphorus and boron masks may be determined according to desired layouts of the trigger regions and the emitter regions as shown in Fig. 4 to Fig. 8. During the driving in, the remaining surfaces may be covered with corresponding oxide or nitride masks.

Optionally, the step of forming (S102) the trigger and emitter regions may comprise:
S1023: pre-depositing and driving in boron for the first and second anode regions, and
S1024: pre-depositing and driving in phosphorus for the first and second blocking regions.

Optionally, the step of forming (S102) the trigger and emitter regions may comprise:
S1025: pre-deposing and driving in phosphorus for the third and fourth trigger regions of the breakover diode structure 90.

Similarly, shapes of the phosphorus and boron masks may be determined according to desired layouts of the anode regions, the blocking regions and trigger regions. During the driving in, the remaining surfaces may also be covered with corresponding oxide or nitride masks. The pre-deposited phosphorus and boron may be phosphorus dopants and boron dopants.

As another option, Fig. 14 shows that: when the thickness of the main electrodes and the guiding region of the gate electrodes are different, the step of forming (S103) the electrodes may further comprise:
S1031: forming a first metal layer on the first and the second surfaces covering centre portions of the first and the second trigger regions, as well as the first and the second emitter regions, and
S1032: forming a second metal layer on the first and the second surfaces covering the first and the second trigger regions, as well as the first and the second emitter regions.

The first metal layer may be formed for the main electrode and centre regions of the gate electrodes while the second metal layer may be formed for the main electrode, as well as the gate electrode including centre regions and guiding regions. As introduced above, with this approach, the portions of the trigger regions that extend along the radial direction is only covered with one metal layer, thereby providing the thinner guiding regions of the gate electrodes.

In addition, to provide the junction termination region, the method may further comprise:
S104: forming the junction termination region 91 by grinding negative bevels at a periphery of the semiconductor body,
S105: surface passivation, and
S106: electron irradiation in junction termination region and/or regions nearest surrounding the junction termination region,

The effect of the electron irradiation leads to the higher reverse breakdown voltage at the junction termination region 91 and its nearest surrounding regions. In the case of the breakover diode damage during device operation, the damaged area stays within the breakover diode structure, so that no harmful arcing appears at the junction termination.

While the invention has been illustrated and described in detail in the drawings and foregoing description, such illustration and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope. The figures are for illustrative purposes only and are not scalable.

### Reference signs list

1 semiconductor device
10 first thyristor structure
20 second thyristor structure
30 semiconductor body
31 first surface
32 second surface
33 first base layer
34 second base layer
35 third base layer
36 third trigger region
37 fourth trigger region
38 first blocking junction
381 first protruding platform
39 second blocking junction
391 second protruding platform
41 first gate electrode
411 first guiding region
42 second gate electrode
421 second guiding region
51 first main electrode
52 second main electrode
53 first metal contact layer
54 second metal contact layer
61 first trigger region
62 second trigger region
71 first emitter region
72 second emitter region
73 first anode region
74 second anode region
75 first blocking region
76 second blocking region
77 third anode region
78 fourth anode region
81 first sacrificial region
82 second sacrificial region
90 breakover diode structure
91 junction termination region
100 bypass circuit
110 first gate circuit
111 first switch
112 first regulating impedance
120 second gate circuit
121 second switch
122 second regulating impedance

## Claims

1. A semiconductor device (1) comprising:
a first thyristor structure (10) and a second thyristor structure (20) antiparallel connected to each other,
a semiconductor body (30) extending in an axial direction with a first surface (31) and a second surface (32) opposite to the first surface (31),
a first gate electrode (41) and a first main electrode (51) disposed on the first surface (31) and spaced from each other,
a second gate electrode (42) and a second main electrode (52) disposed on the second surface (32) and spaced from each other, wherein
the semiconductor body (30) comprises a first base layer (33) of a first conductivity type, a second base layer (34) of a second conductivity type and a third base layer (35) of the first conductivity type stacked in the axial direction, the second conductivity type is different from the first conductivity type,
the first gate electrode (41) comprises a first guiding region (411) extending in a radial direction on the first surface (31),
the second gate electrode (42) comprises a second guiding region (421) extending in a radial direction on the second surface (32),
a first trigger region (61) of the first conductivity type is disposed in the first base layer (33) facing the first guiding region (411), the first gate electrode (41) is electrically connected to the first trigger region (61), the first trigger region (61) has a doping concentration higher than the first base layer (33),
a second trigger region (62) of the first conductivity type is disposed in the third base layer (35) facing the second guiding region (421), the second gate electrode (42) is electrically connected to the second trigger region (62), the second trigger region (61) has a doping concentration higher than the third base layer (35),
a first emitter region (71) of the second conductivity type is disposed in the first base layer (33) facing the first main electrode (51) and is radially spaced from the first trigger region (61), the first main electrode (51) is electrically connected to the first emitter region (71) and the first base layer (33), the first emitter region (71) has a doping concentration higher than the first base layer (33), and
a second emitter region (72) of the second conductivity type is disposed in the third base layer (35) facing the second main electrode (52) and is radially spaced from the second trigger region (62), the second main electrode (52) is electrically connected to the second emitter region (72) and the third base layer (35), the second emitter region (72) has a doping concentration higher than the third base layer (35).

2. The semiconductor device (1) according to the previous claim, wherein
the first base layer (33) and the second base layer (34) form a first blocking junction (38),
the third base layer (35) and the second base layer (34) form a second blocking junction (39),
the first blocking junction (38) comprises a first protruding platform (381) toward the first trigger region (72) and at least part of the first emitter region (71) and
the second blocking junction (39) comprises a second protruding platform (391) toward the second trigger region (62) and at least part of the second emitter region (72).

3. The semiconductor device (1) according to the previous claim, wherein semiconductor device (1) further comprises a first anode region (73) of the first conductivity type and a second anode region (74) of the first conductivity type,
the first anode region (73) is disposed in the first base layer (33) facing the first main electrode (51), the first anode region (73) is radially aligned to the first emitter region (71), the first main electrode (51) is electrically connected to the first anode region (73), the first anode region (73) has a doping concentration higher than the first base layer (33),
the second anode region (74) is disposed in the third base layer (35) facing the second main electrode (52), the second anode regions (74) is radially aligned to the second emitter region (72), the second main electrode (52) is electrically connected to the second anode region (74), and the second anode region (74) has a doping concentration higher than the third base layer (35).

4. The semiconductor device (1) according to the previous claim, wherein
the first and the second anode regions (73, 74) are disposed in circular regions respectively encircling the first and the second emitter regions (71, 72), and/or
the first anode region (73) is spaced from the first emitter region (71) and the second anode region (74) is spaced from the second emitter region (72).

5. The semiconductor device (1) according to the previous two claim, further comprising a first blocking region (75) of the second conductivity type disposed in the first base layer (33) and a second blocking region (76) of the second conductivity type disposed in the third base layer (35), wherein
the first and the second blocking regions (75, 76) are disposed in circular regions respectively encircling the first and the second anode regions (73, 74),
the first blocking region (75) has a doping concentration higher than the first base layer (33), and
the second blocking region (76) has a doping concentration higher than the third base layer (35).

6. The semiconductor device (1) according to the previous claim 1, wherein when observing along the axial direction,
the first guiding region (411) is angularly offset from the second guiding region (421),
the first emitter region (71) is angularly offset from the second emitter region (72) in a same manner,
the semiconductor device (1) further comprises
a third anode region (77) disposed in the first base layer (33) directly opposite to the second emitter region (72),
and a fourth anode region (78) disposed in the third base layer (35) directly opposite to the first emitter region (71), wherein,
the third anode region (77) is of the first conductive type and has a doping concentration higher than the first base layer (33),
the fourth anode region (78) is of the first conductive type and has a doping concentration higher than the third base layer (35).

7. The semiconductor device (1) according to any one of the previous claims, comprising:
multiple first guiding regions (411) extending in different radial directions,
multiple second guiding regions (421) extending in different radial directions,
multiple first trigger regions (61) each disposed in the first base layer (33) facing one of the multiple first guiding regions (411),
multiple second trigger regions (62) each disposed in the third base layer (35) facing one of the multiple second guiding regions (411),
multiple first emitter regions (71) disposed in the first base layer (33) facing the first main electrode (51) and radially aligned to the multiple first trigger regions (61) to form multiple first sacrificial regions (81), and
multiple second emitter regions (72) disposed in the third base layer (35) facing the second main electrode (51) and radially aligned to the multiple second trigger region (62) to form multiple second sacrificial regions (82), and/or
the first emitter region (71) is disposed in a circular region encircling the multiple first trigger regions (61) to form the multiple first sacrificial regions (81), and
the second emitter region (72) is disposed in a circular region encircling the multiple second trigger regions (62) to form the multiple second sacrificial regions (82).

8. The semiconductor device (1) according to the previous claim, wherein, the number of the first and the second sacrificial regions are between 2 to 8, preferably, between 3 to 6.

9. The semiconductor device (1) according to any one of the previous claims, further comprising a breakover diode structure (90) encircling the first and the second thyristor structures (10, 20), wherein
the semiconductor body (30) further comprises
a third trigger region (36) of the first conductivity type disposed in the first based layer (33) facing the first main electrode (51), the third trigger region (36) is disposed in a circular region encircling the first emitter region (71) and is spaced from the first emitter region (71), the third trigger region (36) has a doping concentration higher than the first base layer (33) and equal to or lower than the first trigger region (61),
a fourth trigger region (37) of the first conductivity type disposed in the third based layer (35) facing the second main electrode (52), the fourth trigger region (37) is disposed in a circular region encircling the second emitter region (72) and is spaced from the second emitter region (72), the fourth trigger region (37) has a doping concentration higher than the third base layer (35) and equal to or lower than the second trigger region (62).

10. The semiconductor device (1) according to the previous two claims, wherein
the semiconductor body (30) comprises a junction termination region (91) extending outside an outer circumference of the first main electrode (51) and an outer circumference of the second main electrode (52),
the junction termination region (91) encircles the breakover diode structure (90), and
the junction termination region has a reverse breakdown voltage *V_{BR}* higher than a breakover voltage *V_{BO}* of the breakover diode structure (90).

11. The semiconductor device (1) according to the previous claim, wherein
a vertical thickness of the semiconductor body (30) is gradually reduced from the outer circumferences of the first and the second main electrodes (51, 52) to a circumferential side the semiconductor body (30).

12. The semiconductor device (1) according to any one of the previous three claims, wherein
a depth (*d*₁) of the first blocking junction (38) in at least part of the first thyristor structure (10) is smaller than a depth (*d_{BOD_1}*) of the first blocking junction in the breakover diode structure (90), and
a depth (*d*₂) of the second blocking junction (39) in at least part of the second thyristor structure (20) is smaller than a depth (*d_{BOD_2}*) of the second blocking junction (39) in the breakover diode structure (90).

13. The semiconductor device (1) according to any one of the previous claims, wherein
a thickness of the first main electrode (51) is larger than a thickness of the first guiding region (411), and
a thickness of the second main electrode (52) is larger than a thickness of the second guiding region (421).

14. A bypass circuit (100) comprising a semiconductor device (1) according to any one of the previous claims,
a first gate circuit (110) electrically connected to the first gate electrode (41) and the first main electrode (51), and
a second gate circuit (120) electrically connected to the second gate electrode (42) and the first main electrode (52), wherein,
the first gate circuit (110) is configured to supply a gate driving voltage to the first gate electrode (41) to induce a first gate pulse current flowing from the first trigger region (61) to the first emitter region (71), and
the second gate circuit (120) is configured to supply a gate driving voltage to the second gate electrode (42) to induce a second gate pulse current flowing from the second trigger region (62) to the second emitter region (72).

15. A method for manufacturing in particular a semiconductor device (1) according to any one of the previous claims, comprising the steps of:
forming (S101) a semiconductor body (30) with a first base layer (33) of a first conductivity type, a second base layer (34) of a second conductivity type and a third base layer (35) of the first conductivity type stacked in the axial direction,
forming (S102) a first trigger region (61) of the first conductivity type and a first emitter region (71) of the second conductivity type in the first base layer (35), and a second trigger region (62) of the first conductivity type and a second emitter region (72) of the second conductivity type in the third base layer (36),
forming (S103) a first gate electrode (41) towards the first trigger region (61) and a first main electrode (51) towards the first emitter region (71), and a second gate electrode (41) towards the second trigger region (61) and a second main electrode (51) towards the second emitter region (71),
the second conductivity type is different from the first conductivity type, and
doping concentrations of the first trigger region (61), the second trigger region (62), the first emitter region (71) and the second emitter region (72) are higher than the first and the third base layers (33, 35).

## Amended claims

### Amended claims in accordance with Rule 137(2) EPC.

1. A semiconductor device (1) comprising:
a first thyristor structure (10) and a second thyristor structure (20) antiparallel connected to each other,
a semiconductor body (30) extending in an axial direction with a first surface (31) and a second surface (32) opposite to the first surface (31),
a first gate electrode (41) and a first main electrode (51) disposed on the first surface (31) and spaced from each other,
a second gate electrode (42) and a second main electrode (52) disposed on the second surface (32) and spaced from each other, wherein
the semiconductor body (30) comprises a first base layer (33) of a first conductivity type, a second base layer (34) of a second conductivity type and a third base layer (35) of the first conductivity type stacked in the axial direction, the second conductivity type is different from the first conductivity type,
the first gate electrode (41) is disposed at the center of the first surface (31) and comprises a first guiding region (411) extending in a radial direction on the first surface (31),
the second gate electrode (42) is disposed at the center of the second surface (32) and comprises a second guiding region (421) extending in a radial direction on the second surface (32),
a first trigger region (61) of the first conductivity type is disposed in the first base layer (33) facing the first guiding region (411), the first gate electrode (41) is electrically connected to the first trigger region (61), the first trigger region (61) is a gate region of the first thyristor structure (10) and has a doping concentration higher than the first base layer (33),
a second trigger region (62) of the first conductivity type is disposed in the third base layer (35) facing the second guiding region (421), the second gate electrode (42) is electrically connected to the second trigger region (62), the second trigger region (62) is a gate region of the second thyristor structure (20) and has a doping concentration higher than the third base layer (35),
a first emitter region (71) of the second conductivity type is disposed in the first base layer (33) facing the first main electrode (51) and is radially spaced from an end of the first trigger region (61) by the first base layer (33), the first main electrode (51) is electrically connected to the first emitter region (71) and the first base layer (33), the first emitter region (71) has a doping concentration higher than the first base layer (33), and
a second emitter region (72) of the second conductivity type is disposed in the third base layer (35) facing the second main electrode (52) and is radially spaced from an end of the second trigger region (62) by the third base layer (35), the second main electrode (52) is electrically connected to the second emitter region (72) and the third base layer (35), the second emitter region (72) has a doping concentration higher than the third base layer (35).

2. The semiconductor device (1) according to the previous claim, wherein
the first base layer (33) and the second base layer (34) form a first blocking junction (38),
the third base layer (35) and the second base layer (34) form a second blocking junction (39),
the first blocking junction (38) comprises a first protruding platform (381) protruding toward the first trigger region (72) and at least part of the first emitter region (71) to form a shallow portion of the first blocking junction (38) and
the second blocking junction (39) comprises a second protruding platform (391) protruding toward the second trigger region (62) and at least part of the second emitter region (72) to form a shallow portion of the second blocking junction (39).

3. The semiconductor device (1) according to the previous claim, wherein semiconductor device (1) further comprises a first anode region (73) of the first conductivity type and a second anode region (74) of the first conductivity type,
the first anode region (73) is disposed in the first base layer (33) facing the first main electrode (51), the first anode region (73) is radially aligned to the first emitter region (71), the first main electrode (51) is electrically connected to the first anode region (73), the first anode region (73) has a doping concentration higher than the first base layer (33),
the second anode region (74) is disposed in the third base layer (35) facing the second main electrode (52), the second anode regions (74) is radially aligned to the second emitter region (72), the second main electrode (52) is electrically connected to the second anode region (74), and the second anode region (74) has a doping concentration higher than the third base layer (35).

4. The semiconductor device (1) according to the previous claim, wherein
the first and the second anode regions (73, 74) are disposed in circular regions respectively encircling the first and the second emitter regions (71, 72), and/or
the first anode region (73) is spaced from the first emitter region (71) and the second anode region (74) is spaced from the second emitter region (72).

5. The semiconductor device (1) according to the previous two claim, further comprising a first blocking region (75) of the second conductivity type disposed in the first base layer (33) and a second blocking region (76) of the second conductivity type disposed in the third base layer (35), wherein
the first and the second blocking regions (75, 76) are disposed in circular regions respectively encircling the first and the second anode regions (73, 74),
the first blocking region (75) has a doping concentration higher than the first base layer (33), and
the second blocking region (76) has a doping concentration higher than the third base layer (35).

6. The semiconductor device (1) according to claim 1, wherein when observing along the axial direction,
the first guiding region (411) is angularly offset from the second guiding region (421),
the first emitter region (71) is angularly offset from the second emitter region (72) in a same manner,
the semiconductor device (1) further comprises
a third anode region (77) disposed in the first base layer (33) directly opposite to the second emitter region (72),
and a fourth anode region (78) disposed in the third base layer (35) directly opposite to the first emitter region (71), wherein,
the third anode region (77) is of the first conductive type and has a doping concentration higher than the first base layer (33),
the fourth anode region (78) is of the first conductive type and has a doping concentration higher than the third base layer (35).

7. The semiconductor device (1) according to any one of the previous claims, comprising:
multiple first guiding regions (411) extending in different radial directions,
multiple second guiding regions (421) extending in different radial directions,
multiple first trigger regions (61) each disposed in the first base layer (33) facing one of the multiple first guiding regions (411),
multiple second trigger regions (62) each disposed in the third base layer (35) facing one of the multiple second guiding regions (411),
multiple first emitter regions (71) disposed in the first base layer (33) facing the first main electrode (51) and radially aligned to the multiple first trigger regions (61) to form multiple first sacrificial regions (81), and
multiple second emitter regions (72) disposed in the third base layer (35) facing the second main electrode (51) and radially aligned to the multiple second trigger region (62) to form multiple second sacrificial regions (82), and/or
the first emitter region (71) is disposed in a circular region encircling the multiple first trigger regions (61) to form the multiple first sacrificial regions (81), and
the second emitter region (72) is disposed in a circular region encircling the multiple second trigger regions (62) to form the multiple second sacrificial regions (82),
wherein the first and second sacrificial regions are regions where the first and second blocking junctions are destroyed in response to a gate driving voltage.

8. The semiconductor device (1) according to the previous claim, wherein, the number of the first and the second sacrificial regions are between 2 to 8, preferably, between 3 to 6.

9. The semiconductor device (1) according to any one of the previous claims, further comprising a breakover diode structure (90) encircling the first and the second thyristor structures (10, 20), wherein
the semiconductor body (30) further comprises
a third trigger region (36) of the first conductivity type disposed in the first based layer (33) facing the first main electrode (51), the third trigger region (36) is disposed in a circular region encircling the first emitter region (71) and is spaced from the first emitter region (71), the third trigger region (36) has a doping concentration higher than the first base layer (33) and equal to or lower than the first trigger region (61),
a fourth trigger region (37) of the first conductivity type disposed in the third based layer (35) facing the second main electrode (52), the fourth trigger region (37) is disposed in a circular region encircling the second emitter region (72) and is spaced from the second emitter region (72), the fourth trigger region (37) has a doping concentration higher than the third base layer (35) and equal to or lower than the second trigger region (62).

10. The semiconductor device (1) according to the previous two claims, wherein
the semiconductor body (30) comprises a junction termination region (91) extending outside an outer circumference of the first main electrode (51) and an outer circumference of the second main electrode (52),
the junction termination region (91) encircles the breakover diode structure (90), and
the junction termination region has a reverse breakdown voltage *V_{BR}* higher than a breakover voltage *V_{BO}* of the breakover diode structure (90).

11. The semiconductor device (1) according to the previous claim, wherein
a vertical thickness of the semiconductor body (30) is gradually reduced from the outer circumferences of the first and the second main electrodes (51, 52) to a circumferential side the semiconductor body (30).

12. The semiconductor device (1) according to any one of the previous three claims, wherein
a depth (*d*₁) of the first blocking junction (38) in at least part of the first thyristor structure (10) is smaller than a depth (*d*_{*BOD*_1}) of the first blocking junction in the breakover diode structure (90), and
a depth (*d*₂) of the second blocking junction (39) in at least part of the second thyristor structure (20) is smaller than a depth (*d*_{*BOD*_2}) of the second blocking junction (39) in the breakover diode structure (90).

13. The semiconductor device (1) according to any one of the previous claims, wherein
a thickness of the first main electrode (51) is larger than a thickness of the first guiding region (411), and
a thickness of the second main electrode (52) is larger than a thickness of the second guiding region (421).

14. A bypass circuit (100) comprising a semiconductor device (1) according to any one of the previous claims,
a first gate circuit (110) electrically connected to the first gate electrode (41) and the first main electrode (51), and
a second gate circuit (120) electrically connected to the second gate electrode (42) and the first main electrode (52), wherein,
the first gate circuit (110) is configured to supply a gate driving voltage to the first gate electrode (41) to induce a first gate pulse current flowing from the first trigger region (61) to the first emitter region (71), and
the second gate circuit (120) is configured to supply a gate driving voltage to the second gate electrode (42) to induce a second gate pulse current flowing from the second trigger region (62) to the second emitter region (72).

15. A method for manufacturing in particular a semiconductor device (1) according to any one of the previous claims, comprising the steps of:
forming (S101) a semiconductor body (30) with a first base layer (33) of a first conductivity type, a second base layer (34) of a second conductivity type and a third base layer (35) of the first conductivity type stacked in the axial direction,
forming (S102) a first trigger region (61) of the first conductivity type and a first emitter region (71) of the second conductivity type in the first base layer (35), and a second trigger region (62) of the first conductivity type and a second emitter region (72) of the second conductivity type in the third base layer (36),
forming (S103) a first gate electrode (41) towards the first trigger region (61) and a first main electrode (51) towards the first emitter region (71), and a second gate electrode (41) towards the second trigger region (61) and a second main electrode (51) towards the second emitter region (71),
the second conductivity type is different from the first conductivity type, and
doping concentrations of the first trigger region (61), the second trigger region (62), the first emitter region (71) and the second emitter region (72) are higher than the first and the third base layers (33, 35).
